# EUROPÄISCHE PATENTANMELDUNG

(11) **EP 2 136 403 A2**
(43) Veröffentlichungstag der Anmeldung: **23.12.2009**
(21) Anmeldenummer: 08105840.6
(22) Anmeldetag: 21.11.2008
(51) Int. Cl.: H01L 27/146

(54) **Bildaufnahmeanordnung und Nachtsichtsystem mit einer Bildaufnahmeanordnung**

(30) Priorität: 20.06.2008 DE 102008002553
(71) Anmelder: ROBERT BOSCH GMBH, 70442 Stuttgart (DE)
(72) Erfinder: Schmack, Andreas, 71229 Leonberg (DE); Franz, Gerald, 71522 Backnang (DE)

(57) **Zusammenfassung**

Die Erfindung betrifft eine Bildaufnahmeanordnung und ein Nachtsichtsystem eines Fahrzeugs, das eine derartige Bildaufnahmeanordnung umfasst.

Die Bildaufnahmeanordnung umfasst einen Bildsensor (1a, 1 b), ein Polarisationsfilter (2a, 2b) zum Filtern von Licht (9-1), insbesondere im sichtbaren, ultravioletten oder infraroten Wellenlängenbereich, in Abhängigkeit von dessen Polarisationsebene, und ein optisch aktives Mittel (3a, 3b) zum Drehen der Polarisationsebene von Licht (9-2), wobei das Polarisationsfilter (2a, 2b) und das optisch aktive Mittel (3a, 3b) in einem gemeinsamen Strahlengang vor dem Bildsensor (1a, 1 b) so angeordnet sind, dass zumindest ein Teil des einfallenden Lichtes (9-1) zunächst auf das Polarisationsfilter (2a, 2b), dann auf das optisch aktive Mittel (3a, 3b) und dann auf den Bildsensor (1 a, 1 b) trifft.

## Beschreibung

### Stand der Technik

Bei der Konstruktion einer Bildaufnahmeanordnung, wie einer Kamera mit Bildsensoren, sind Streulichteffekte problematisch. Streulichteffekte werden unter anderem dadurch erzeugt, dass Reflektionen an verschiedenen Flächen und Kanten innerhalb einer Optik bzw. entlang eines optischen Pfades der Kamera auftreten. Es wird versucht, derartige Streulichteffekte zu reduzieren, indem Kanten möglichst weit aus dem optischen Pfad entfernt, Oberflächen geschwärzt und Glasflächen hoch vergütet werden. Die Fläche des Bildsensors jedoch kann nicht vergütet werden, Reflektionen an dessen Oberfläche lassen sich nicht verhindern. Ein Bildsensor beispielsweise auf der Basis von Silizium reflektiert ca. 50 bis 70 Prozent der einfallenden Strahlung zurück. Trifft dieses reflektierte Licht auf eine weitere reflektierende Fläche, so wird es wieder zum Bildsensor zurückgeworfen. Die Folge davon sind Aufhellungen im Kamerabild und so genannte Ghosts bzw. Doppelbilder.

Eine Verwendung einer Kamera mit einem Bildsensor ist in einem Nachtsichtsystem eines Fahrzeuges. Die Druckschrift EP 0 490 029 A2 offenbart ein aktives Nachtsichtsystem für ein Fahrzeug, das neben einer Kamera als weiteres Element eine Beleuchtungsanordnung umfasst. Die Beleuchtungsanordnung ist derart eingerichtet, dass sie polarisiertes Licht aussendet. Die Kamera weist einen Polarisator bzw. Polarisationsfilter auf, der einfallendes Licht, dessen Polarisationsebene nicht der dem Polarisator zugeordneten Polarisationsebene entspricht, sperrt.

Trifft von der Beleuchtungsanordnung ausgestrahltes Licht auf Objekte der Umgebung, so wird das Licht gestreut. Aufgrund der Streuung geht die vormals einheitliche Polarisierung des Lichtes verloren. Trifft das gestreute Licht auf die Kamera, so kann ein Anteil des Lichtes den Polarisator der Kamera passieren und von dem Bildsensor der Kamera registriert werden.

Ausgestrahltes polarisiertes Licht eines zweiten aktiven Nachtsichtsystems, insbesondere eines entgegenkommenden Fahrzeugs, kann bei einer geeigneten Anordnung von Polarisator und Beleuchtungsanordnung durch den Polarisator der Kamera gesperrt werden. Auf diese Weise kann vermieden werden, dass die Kamera durch Licht entgegenkommender Fahrzeuge, das eine weitaus höhere Intensität besitzt als das gestreute Licht, überstrahlt oder geblendet wird.

Trotz des Einsatzes von polarisiertem Licht bei der Beleuchtungsanordnung und dem Polarisator in der Bildaufnahmeanordnung, d. h., der Kamera, kann der Bildsensor durch unerwünschte Reflexionswege, wie oben beschrieben, von dem Licht der entgegenkommenden Fahrzeuge überstrahlt oder geblendet werden. Dies beeinträchtigt die Funktion eines derartigen aktiven Nachtsichtsystems.

### Offenbarung der Erfindung

Die erfindungsgemäße Bildaufnahmeanordnung umfasst mindestens einen Bildsensor, ein Polarisationsfilter zum Filtern von Licht, insbesondere im sichtbaren, ultravioletten oder infraroten Wellenlängenbereich, in Abhängigkeit von dessen Polarisationsebene, und ein optisch aktives Mittel zum Drehen der Polarisationsebene von Licht, wobei das Polarisationsfilter und das optisch aktive Mittel in einem gemeinsamen Strahlengang vor dem Bildsensor so angeordnet sind, dass zumindest ein Teil des einfallenden Lichtes zunächst auf das Polarisationsfilter, dann auf das optisch aktive Mittel und dann auf den Bildsensor trifft.

Einfallendes Licht wird durch das Polarisationsfilter polarisiert, d.h. bezüglich seiner Polarisationsebene gefiltert. Nachfolgend trifft das Licht auf das optisch aktive Mittel, wodurch die Polarisationsebene des Lichtes um einen bestimmten Winkel gedreht wird. Danach trifft das Licht auf den Bildsensor. Der Anteil des Lichtes, der am Bildsensor reflektiert wird, trifft ein zweites Mal auf das optisch aktive Mittel, wodurch die Polarisationsebene des Lichtes ein zweites Mal um einen bestimmten Winkel gedreht wird. Schließlich trifft dieser reflektierte Lichtanteil wieder auf das Polarisationsfilter. Durch die Wahl des Winkels, um den das optisch aktive Mittel die Polarisationsebene des Lichtes drehen soll, kann bewirkt werden, dass der reflektierte Lichtanteil beim Auftreffen auf das Polarisationsfilter eine Polarisationsebene aufweist, die von der Polarisationsebene, die das Polarisationsfilter passieren lässt, abweicht, so dass das Polarisationsfilter zumindest einen Anteil des am Bildsensor reflektierten Lichtanteils sperrt.

Vorzugsweise ist das Polarisationsfilter derart ausgebildet, das es den Lichtanteil, den es sperrt, zumindest teilweise, vorteilhafterweise weitgehend absorbiert. Auf diese Weise lässt sich verhindern, dass dieser Lichtanteil durch Reflektion erneut auf den Bildsensor fällt und dort zu unerwünschten Effekten führt.

Des Weiteren ist bevorzugt das optisch aktive Mittel derart ausgebildet, dass es die Polarisationsebene des Lichtes um etwa 45 Grad bzw. λ/8 bei der Wellenlänge λ dreht. Durch zweimaliges Treffen auf das optisch aktive Mittel wird in diesem Falle die Polarisationsebene des Lichtes um insgesamt 90 Grad bzw. λ/4 gedreht, wodurch die Sperrung des am Bildsensor reflektierten Lichtanteils durch das Polarisationsfilter maximiert ist. Es können auch andere Winkel gewählt werden, möglicherweise verringert sich aber dann die Effektivität der Anordnung, Streulicht zu reduzieren. Ebenso können weitere Mittel vorgesehen sein, die die Polarisationsebene des Lichtes drehen.

In einer vorteilhaften Ausführungsform sind zwischen dem Polarisationsfilter und dem optisch aktiven Mittel im Strahlengang Bildsensor - Polarisationsfilter - optisch aktives Mittel keine weiteren optischen Komponenten angeordnet. Solche optischen Komponenten würden möglicherweise zu Streulicht führen, das nicht unterdrückt werden könnte. Die genannte Anordnung ist somit vorteilhaft für eine hohe Effektivität der Streulichtreduzierung.

Das erfindungsgemäße aktive Nachtsichtsystem eines Fahrzeugs umfasst eine erfindungsgemäße Bildaufnahmeanordnung und eine Beleuchtungsanordnung, wobei die Beleuchtungsanordnung so ausgebildet ist, dass diese polarisiertes Licht zur Beleuchtung der Umgebung aussendet, und das Polarisationsfilter der Bildaufnahmeanordnung auf diese Polarität ausgerichtet ist.

Durch den Einsatz der erfindungsgemäßen Bildaufnahmeanordnung kann störendes Streulicht, das insbesondere durch einfallendes Licht von entgegenkommenden Fahrzeugen erzeugt wird, reduziert werden, wodurch sich eine Überstrahlung und Blendung des Bildsensors der Bildaufnahmeanordnung vermindern oder sogar eliminieren lässt.

### Kurze Beschreibung der Zeichnungen

Die Erfindung wird nun anhand von Ausführungsbeispielen, welche teilweise durch Figuren dargestellt sind, näher erläutert. Dabei zeigt:
- Fig. 1a: eine erste Ausführungsform einer erfindungsgemäßen Bildaufnahmeanordnung;
- Fig. 1b: eine zu Fig. 1 abgewandelte zweite Ausführungsform;
- Fig. 2: eine dritte Ausführungsform einer erfindungsgemäßen Bildaufnahmeanordnung;
- Fig. 3: ein erfindungsgemäßes Nachtsichtsystem mit einer erfindungsgemäßen Bildaufnahmeanordnung;
- Fig. 4: eine Fahrszene eines Fahrzeugs mit dem erfindungsgemäßen Nachtsichtsystem aus Fig. 3 in Draufsicht.

Gleiche oder einander entsprechende Gegenstände sind mit den selben oder entsprechenden Bezugszeichen gekennzeichnet.

### Ausführungsformen der Erfindung

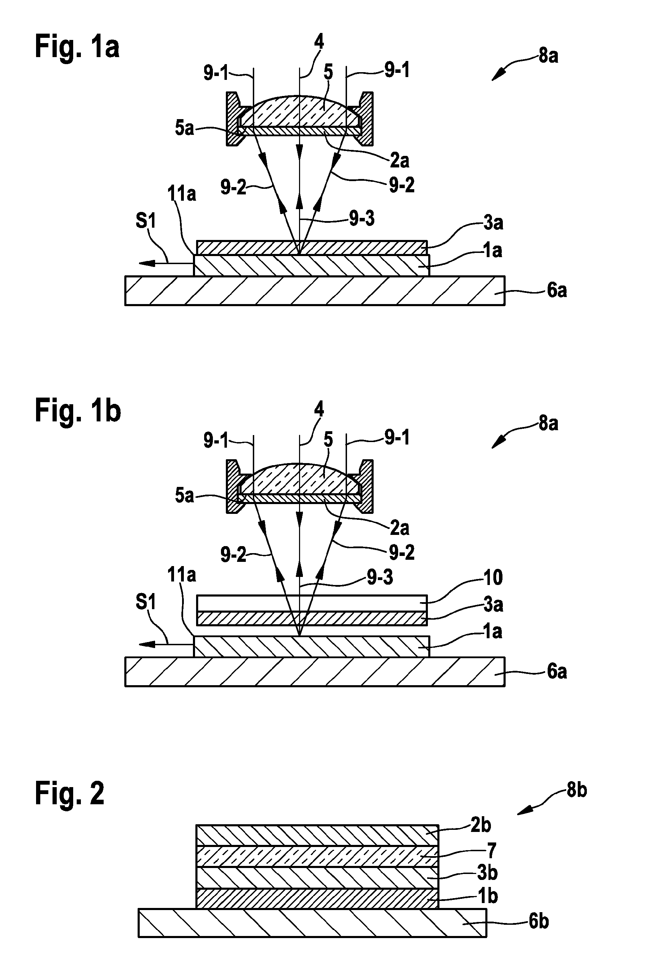

Figur 1a zeigt eine erste Ausführungsform einer erfindungsgemäßen Bildaufnahmeanordnung 8a, die einen Bildsensor 1a, hier einen CMOS- oder CCD-Sensor auf Silizium-Basis, ein Polarisationsfilter 2a zum Polarisieren von Licht, insbesondere im sichtbaren, infraroten oder ultravioletten Bereich, ein optisch aktives Mittel 3a zum Drehen der Polarisationsebene von Licht, hier eine optisch aktive Schicht 3a, eine Linse 5 und einen Träger 6a umfasst, auf dem der Bildsensor 1a angeordnet ist. Eine optische Achse 4 definiert hierbei den Strahlengang.

Die Linse 5 ist konvex-plan mit konvexer Vorderfläche ausgebildet und mit einem Abstand zum Bildsensor 1a angeordnet. Durch die Linse 5 wird parallel einfallendes Licht 9-1 entlang der optischen Achse 4 gebündelt. Das Polarisationsfilter 2a ist als Schicht auf die plane, dem Bildsensor 1a zugewandte Unterseite 5a der Linse 5 aufgebracht. Die optisch aktive Schicht 3a ist direkt auf der der Linse 5 zugewandten Oberfläche 11a des Bildsensors 1a aufgebracht. Das Polarisationsfilter 2a ist dabei derart ausgebildet, dass es Licht 9 in einer bestimmten Vorzugs-Polarisationsebene durchlässt und anderes Licht absorbiert. Die optisch aktive Schicht 3a ist derart ausgebildet, dass sie die Polarisationsebene des Lichtes um 45 Grad dreht. Zwischen dem Polarisationsfilter 2a und der optisch aktiven Schicht 3a befinden sich im Strahlengang Polarisationsfilter 2a - optisch aktive Schicht 3a - Bildsensor 1a in dieser Ausführungsform keine weiteren optischen Komponenten auf; auch ist vorteilhafterweise keine weitere Abdeckung des Bildsensors 1a erforderlich, da er durch die Schicht 3a geschützt ist.

Alternativ hierzu kann gemäß Fig. 1b ein Glaslid 10 bzw. eine Glasscheibe von dem Bildsensor 1a beabstandet, d.h. zwischen dem Bildsensor 1a und dem Polarisationsfilter 2a vorgesehen sein, wobei das Glaslid 10 auf seiner Ober- und/oder Unterseite vergütet sein kann. Vorteilhafterweise das optisch aktive Mittel 3a als optisch aktive Schicht auf der Ober- und/oder Unterseite des Glaslids 10 aufgebracht.

Bei beiden Ausführungsformen der Fig. 1 a, b trifft einfallendes Licht 9-1 nach Passieren der Linse 5 auf das Polarisationsfilter 2a und wird durch dieses gefiltert. Der Lichtanteil 9-2 mit zulässiger Polarisationsrichtung tritt nachfolgend durch die optisch aktive Schicht 3a hindurch und trifft auf den Bildsensor 1a. Der Lichtanteil mit nicht zulässiger Polarisationsrichtung (d.h. insbesondere Licht mit zu der Vorzugs- Polarisationsebene orthogonaler Polarisationsebene) wird vom Polarisationsfilter 2a absorbiert. Der Bildsensor 1a absorbiert etwa 30 bis 50 Prozent des Lichtes 9-2, wobei ein Teil in elektrische Ladung zur Ausgabe eines Bildsignals S1 umgewandelt wird. Die restlichen 50 bis 70 Prozent werden als Lichtanteil 9-3 zurück reflektiert und passieren erneut die optisch aktive Schicht 3a. Die Polarisationsebene des am Bildsensor 1a reflektierten Lichtanteils 9-3 ist damit insgesamt um 90 Grad gedreht. Dieser reflektierte und gedrehte Lichtanteil 9-3 trifft nun auf das Polarisationsfilter 2a und wird durch dieses ganz oder nahezu vollständig absorbiert. Es wird somit verhindert, dass weitere Reflexionen entstehen und Lichtanteile unerwünscht auf den Bildsensor 1a treffen. Ein hoher Absorptionsgrad und geringe Reflexion des Polarisationsfilters 2a sind dabei für diesen Zweck besonders vorteilhaft.

In einer Variante hierzu können das Polarisationsfilter 2a und/oder das optisch aktive Mittel 3a als diskrete Bauteile ausgebildet sein.

Figur 2 zeigt eine weitere Ausführungsform einer erfindungsgemäßen Bildaufnahmeanordnung. Die Bildaufnahmeanordnung 8b umfasst einen Bildsensor 1b, ein Polarisationsfilter 2b zum Polarisieren von Licht und ein optisch aktives Mittel 3b zum Drehen der Polarisationsebene von Licht, hier eine optisch aktive Schicht 3b. Das Polarisationsfilter 2b, die optisch aktive Schicht 3b und der Bildsensor 1b sind als Schichten eines Schichtsystems ausgebildet. Die Unterseite des Bildsensors 1b ist dabei auf einem Träger 6b angeordnet. Über dem Bildsensor 1b folgt unmittelbar die optisch aktive Schicht 3b. Als nächste Schicht folgt ein transparenter Körper, hier eine Glasscheibe 7, die als Schutzschicht für den Bildsensor 1b ausgebildet ist. Das Schichtsystem wird durch das Polarisationsfilter 2b abgeschlossen, das die oberste Schicht bildet. Auch bei dieser Ausführungsform absorbiert das Polarisationsfilter 2b das nicht durchgelassene Licht.

Alternativ lässt sich das Polarisationsfilter 2b auch auf der Unterseite der Glasscheibe 7 anordnen.

In einer weiteren Variante kann das Polarisationsfilter 2b als Schicht auf der dem Bildsensor 1b abgewandten Oberseite der Glasscheibe 7 und das optisch aktive Mittel 3b zum Drehen der Polarisationsebene von Licht als optisch aktive Schicht auf der Unterseite der Glasscheibe 7 aufgebracht sein, wobei zwischen dem Bildsensor 1b und dem optisch aktivem Mittel 3b lediglich ein schmaler Luftspalt verbleibt. Alternativ hierzu kann auch das optisch aktive Mittel 3b direkt auf den Bildsensor 1b sowie das Polarisationsfilter 2b auch auf der Unterseite der Glasscheibe 7 aufgebracht sein.

Als Bildsensoren eignen sich insbesondere bildgebende Sensoren bzw. Pixel-Array-Sensoren, insbesondere CMOS- oder CCD-Sensoren, die ein Bildsignal S1 ausgeben, z. B. zur Bildverarbeitung und Darstellung auf einem Display und/oder zur Auswertung eines Fahrerassistenzsystems.

Materialien, die sich als Polarisationsfilter 2a bzw. 2b eignen, sind dem Fachmann hinlänglich bekannt. Als optisch aktive Mittel eignen sich beispielsweise Beschichtungen oder diskrete Bauteile auf der Basis von Polyphenylenamin oder von chiralen Polyanilinen.

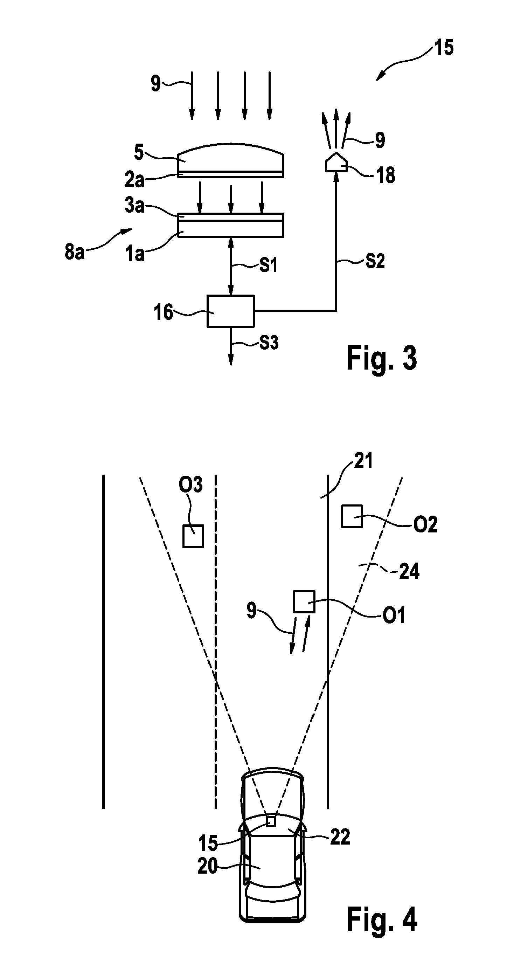

Erfindungsgemäße Bildaufnahmeanordnungen eignen sich insbesondere für ein aktives Nachtsichtsystem eines Fahrzeugs. Fig. 3 zeigt ein erfindungsgemäßes Nachtsichtsystem 15, bei dem eine Steuereinrichtung 16 ein Ansteuersignal S2 an eine Beleuchtungsanordnung 18 zur Ausgabe von polarisierter Strahlung 9 ausgibt, z. B. einen Laser, der polarisiertes Licht (bzw. Strahlung) 9 im nahen Infrarot zur Beleuchtung einer Umgebung abstrahlt. Alternative Beleuchtungsanordnungen 18 sind beispielsweise LEDs oder Gasentladungslampen mit entsprechend eingerichteten Polarisationsvorrichtungen, beispielsweise Polarisationsfiltern. Das erfindungsgemäße Nachtsichtsystem 15 umfasst weiterhin eine Bildaufnahmeanordnung 8a oder 8b gemäß einer der beschriebenen Ausführungsformen, die polarisiertes Licht (bzw. Strahlung) 9 einer Vorzugs-Polarisationsebene empfängt. Bei Verwendung einer Bildaufnahmeanordnung 8a umfasst diese entsprechend ein Polarisationsfilter 2a zum Polarisieren bzw. Polarisations-Filtern des einfallenden Lichts 9. Das Polarisationsfilter 2a, das optisch aktive Mittel 3a und der Bildsensor 1a sind dabei auf einen Wellenlängenbereich im nahen Infrarotbereich abgestimmt, der dem Wellenlängenbereich des von der Beleuchtungsanordnung 18 ausgesandten Lichts 9 entspricht oder zumindest in diesem enthalten ist. Die Beleuchtungsanordnung 18 und die Bildaufnahmeanordnung 8a sind dabei derart ausgerichtet bzw. zueinander orientiert, dass die Polarisationsebene des ausgestrahlten Lichts 9 der dem Polarisationsfilter zugeordneten Vorzugs-Polarisationsebene entspricht.

Die Steuereinrichtung 16 ermittelt aus ihren Ansteuersignalen S2 und den empfangenen Bildsignalen S1 ein Bild sowie gegebenenfalls auch Abstände etc in der erfassten Fahrszene und gibt ein Ausgabesignal S3 z. B. an ein Display bzw. an dessen Steuereinrichtung und/oder an eine Fahrdynamikregelung oder ein Fahrerassistenzsystem zur Bildauswertung aus.

Fig. 4 zeigt ein Fahrzeug 20 mit einem erfindungsgemäßen Nachtsichtsystem 15 auf einer Fahrbahn 21. Das gesamte Nachtsichtsystem 15 oder zumindest die erfindungsgemäße Bildaufnahmeanordnung 8a oder 8b sind vorzugsweise hinter einer Windschutzscheibe 22 des Fahrzeugs 20 angeordnet und erfassen einen Erfassungsbereich 24 der Fahrbahn 21 und seitlicher Bereiche vor, gegebenenfalls auch neben dem Fahrzeug 20. Erfasste Objekte O1, O2, O3 reflektieren einen Teil des ausgegebenen Lichts 9.

Ordnet man ein derartiges Nachtsichtsystem 15 in dem Fahrzeug 20 beispielsweise so an, dass die Polarisationsebene des ausgestrahlten Lichts 9 einen Winkel von 45 Grad bezüglich der Horizontalen einnimmt, die in der Regel durch die Fahrbahn 21 vorgegeben wird, so wird das Licht eines entgegenkommenden, ebenfalls mit einem derartigen Nachtsichtsystem ausgestatteten zweiten Fahrzeugs durch das Polarisationsfilter der Bildaufnahmeanordnung des ersten bzw. eigenen Fahrzeugs 20 gesperrt. Des Weiteren wird durch die erfindungsgemäße Bildaufnahmeanordnung 8a oder 8b das durch unerwünschte Reflexion erzeugte Streulicht reduziert, das auf den Bildsensor 1a oder 1b fällt. Eine Überstrahlung oder Blendung des Bildsensors 1a oder 1b durch Licht des aktiven Nachtsichtsystems eines entgegenkommenden Fahrzeugs kann damit vermieden werden.

## Patentansprüche

1. Bildaufnahmeanordnung, die aufweist:
einen Bildsensor (1a, 1b),
ein Polarisationsfilter (2a, 2b) zum Filtern von Licht (9-1), insbesondere im sichtbaren, ultravioletten oder infraroten Wellenlängenbereich, in Abhängigkeit von dessen Polarisationsebene, und
ein optisch aktives Mittel (3a, 3b) zum Drehen der Polarisationsebene von Licht (9-2),
wobei das Polarisationsfilter (2a, 2b) und das optisch aktive Mittel (3a, 3b) in Richtung des einfallenden Lichts vor dem Bildsensor (1a, 1b) so angeordnet sind, dass zumindest ein Teil des einfallenden Lichtes (9-1) zunächst auf das Polarisationsfilter (2a, 2b), dann auf das optisch aktive Mittel (3a, 3b) und dann auf den Bildsensor (1a, 1b) trifft.

2. Bildaufnahmeanordnung nach Anspruch 1, **dadurch gekennzeichnet, dass** der Lichtanteil (9-3) des einfallenden Lichtes (9-1), der vom Bildsensor (1a, 1b) reflektiert wird, zumindest überwiegend zunächst auf das optisch aktive Mittel (3a, 3b) und dann auf das Polarisationsfilter (2a, 2b) trifft.

3. Bildaufnahmeanordnung nach Anspruch 1 oder 2, **dadurch gekennzeichnet, dass** das Polarisationsfilter (2a, 2b) eine Vorzugs- Polarisationsebene aufweist und Licht, dessen Polarisationsebene in der Vorzugs-Polarisationsebene liegt, zumindest überwiegend durchlässt und Licht, dessen Polarisationsebene von der Vorzugs-Polarisationsebene abweicht, zumindest teilweise absorbiert.

4. Bildaufnahmeanordnung nach Anspruch 3, **dadurch gekennzeichnet, dass** das Polarisationsfilter (2a, 2b) das Licht, dessen Polarisationsebene von der Vorzugs-Polarisationsebene abweicht, weitgehend oder vollständig absorbiert.

5. Bildaufnahmeanordnung nach einem der vorhergehenden Ansprüche, **dadurch gekennzeichnet, dass** das optisch aktive Mittel (3a, 3b) derart ausgebildet ist, dass es die Polarisationsebene des Lichts (9) um etwa 45° dreht.

6. Bildaufnahmeanordnung nach einem der vorhergehenden Ansprüche, **dadurch gekennzeichnet, dass** das Polarisationsfilter (2a, 2b) in Einfallsrichtung des Lichts (9-1) vor dem optisch aktiven Mittel (3a, 3b) und das optisch aktive Mittel (3a, 3b) in Einfallsrichtung des Lichts (9-2) vor dem Bildsensor (1a, 1b) angeordnet ist.

7. Bildaufnahmeanordnung nach Anspruch 6, **dadurch gekennzeichnet, dass** das optisch aktive Mittel (3a, 3b) als optisch aktive Schicht auf der Oberseite des Bildsensors (1a, 1b) angebracht ist.

8. Bildaufnahmeanordnung nach Anspruch 6 oder 7, **dadurch gekennzeichnet, dass** im Strahlengang zwischen dem Polarisationsfilter (2a) und dem optisch aktiven Mittel (3a) keine weiteren optischen Komponenten angeordnet sind.

9. Bildaufnahmeanordnung nach Anspruch 6, **dadurch gekennzeichnet, dass** vor dem Bildsensor (1a) ein transparenter Körper (10) zum Schutz des Bildsensors (1a), z. B. eine Glasscheibe (10), vorgesehen ist und das optisch aktive Mittel (2a) als optisch aktive Schicht (2a) auf der Ober- und/oder Unterseite des transparenten Körpers (10) ausgebildet ist.

10. Bildaufnahmeanordnung nach einem der vorhergehenden Ansprüche, **dadurch gekennzeichnet, dass** das Polarisationsfilter (2a) an der Ober- und/oder Unterseite einer optischen Einrichtung, z. B. einer Linse (5), angebracht ist.

11. Bildaufnahmeanordnung nach Anspruch 6 oder 7, **dadurch gekennzeichnet, dass** das Polarisationsfilter (2b), das optisch aktive Mittel (3b) und der Bildsensor (1 b) als Schichten eines Schichtsystems ausgebildet sind.

12. Bildaufnahmeanordnung nach einem der vorhergehenden Ansprüche, **dadurch gekennzeichnet, dass** der Bildsensor (1a, 1b) ein bildgebender Sensor, insbesondere ein Pixel-Array-Sensor, beispielsweise ein CMOS- oder CCD- Imagerchip, ist.

13. Nachtsichtsystem (15) eines Fahrzeugs (20), umfassend eine Bildaufnahmeanordnung (8a, 8b) nach einem der vorherigen Ansprüche und eine Beleuchtungsanordnung (18) zum Aussenden von polarisierten Licht (9) zur Beleuchtung eines Erfassungsbereichs (24) der Bildaufnahmeanordnung (8a, 8b) außerhalb des Fahrzeugs (20), insbesondere einer Fahrbahn (21).

14. Nachtsichtsystem nach Anspruch 13, **dadurch gekennzeichnet, dass** die Vorzugs-Polarisationsebene des Polarisationsfilters (2a,2b) der Bildaufnahmeanordnung (8a, 8b) und die Polarisationsebene der Beleuchtungsanordnung (18) im wesentlichen gleich sind.

15. Nachtsichtsystem nach Anspruch 13 oder 14, **dadurch gekennzeichnet, dass** Vorzugs-Polarisationsebene des Polarisationsfilters (2a,2b) der Bildaufnahmeanordnung (8a, 8b) und die Polarisationsebene der Beleuchtungsanordnung (18) etwa 45 Grad gegenüber der Horizontalen und/oder der Fahrbahn (21) geneigt sind.
